# EUROPEAN PATENT APPLICATION

(11) **EP 4 578 679 A1**
(43) Date of publication of application: **02.07.2025**
(21) Application number: 22956550.2
(22) Date of filing: 26.08.2022
(51) Int. Cl.: B60K 1/00

(54) **HIGH-VOLTAGE DEVICE IN-VEHICLE STRUCTURE**

(71) Applicant: NISSAN MOTOR CO., LTD., Kanagawa 221-0023 (JP)
(72) Inventor: OZAKI, Michio, Atsugi-shi, Kanagawa 243-0123 (JP); OOKI, Kazuhiro, Atsugi-shi, Kanagawa 243-0123 (JP)
(74) Representative: Hoefer & Partner Patentanwälte mbB
(86) International application number: PCT/JP2022/032274
(87) International publication number: WO 2024/042724

(57) **Abstract**

A structure for installing a high voltage device on a vehicle, includes the high voltage device (1), and an interior component (6) fixed in the passenger compartment adjacent to the high voltage device (1). The high voltage device (1) includes a base member (2) fixed on a mounting surface (P) in a passenger compartment, a high voltage part (3) provided on the base member (2), and a cover member (4) fixed to the base member (2) to cover the high voltage part (3). The cover member (4) is fixed to the base member (2) by fasteners (5). A fastening direction of at least one fastener (5X) of the fasteners (5) to the base member (4) is set parallel to the mounting surface (P), and this fastener (5X) faces the interior component (6) in close proximity in its fastening direction. A fastening direction of remaining fasteners (5) to the base member (4) is set perpendicular to the mounting surface (P).

## Description

### TECHNICAL FIELD

The present invention relates to a structure for installing a high voltage device on a vehicle.

### BACKGROUND ART

A Patent Literature 1 listed below discloses a structure for installing a high voltage device on a vehicle. The vehicle in the Patent Literature 1 is a hybrid electric vehicle (HEV), and the vehicle is installed with a DC/AC inverter for external power supply as the high voltage device. The high voltage device like this is sometimes located in a passenger compartment cabin (including a cargo compartment) due to space limitations in an engine compartment (motor compartment) or the like. The DC/AC inverter houses high voltage parts, which operate at high voltages, within its inside. Note that the high voltage referred to here is a voltage of 60 volts or higher, and the high voltage device requires a dedicated ground circuit instead of body ground, and its harnesses are made orange to distinguish them from other wirings. Note that the DC/AC inverter disclosed in the Patent Literature 1 converts several hundred volts DC power of a battery pack installed on the vehicle to 100 volts AC power (Japanese household power voltage is AC 100 volts).

### CITATION LIST

### PATENT LITERATURE

Patent Literature 1: Japanese Granted Patent Publication No. 5831343

### SUMMARY OF INVENTION

### PROBLEM TO BE SOLVED

Since the high voltage device like this houses the high voltage parts within its inside, it is not desired to be disassembled carelessly by a user. Therefore, it is desired to adopt an on-vehicle installation structure by which it cannot be disassembled by a user. The DC/AC inverter disclosed in the Patent Literature 1 is installed in a recess formed on a floor of a cargo compartment, and a floor plate of the cargo compartment covers the recess. However, the floor plate can be easily removed. Therefore, a user can easily access the high voltage device and disassemble the high voltage device while it is still installed on the vehicle.

An object of the present invention is to provide a structure for installing a high voltage device on a vehicle, which can prevent users from accessing high voltage parts housed therewithin.

### SOLUTION TO PROBLEM

An aspect of the present invention provides a structure for installing a high voltage device on a vehicle, which includes the high voltage device, and an interior component fixed in the passenger compartment adjacent to the high voltage device. The high voltage device includes a base member fixed on a mounting surface in a passenger compartment, a high voltage part provided on the base member, and a cover member fixed to the base member to cover the high voltage part. The cover member is fixed to the base member by fasteners. A fastening direction of at least one fastener of the fasteners to the base member is set parallel to the mounting surface, and the at least one fastener faces the interior component in close proximity in its fastening direction. A fastening direction of all or some remaining fasteners of the fasteners to the base member is set perpendicular to the mounting surface.

### ADVANTAGEOUS EFFECTS

According to the aspect, it is possible to prevent the high voltage device installed on the vehicle from being disassembled by a user and thus prevent the high voltage part housed within it from being accessed by the user.

### BRIEF DESCRIPTION OF DRAWINGS

[FIG. 1] Fig. 1 is a perspective view of a structure for installing a high voltage device on a vehicle according to a first embodiment.
[FIG. 2] Fig. 2 is a side view of the on-vehicle installation structure.
[FIG. 3] Fig. 3 is a perspective view of the high voltage device.
[FIG. 4] Fig. 4 is a perspective view showing a bottom face of the high voltage device.
[FIG. 5] Fig. 5 is a perspective view of a structure for installing a high voltage device on a vehicle according to a second embodiment.
[FIG. 6A] Fig. 6A is a cross-sectional view showing a deflection structure in the on-vehicle installation structure (before fastening).
[FIG. 6B] Fig. 6B is a cross-sectional view showing the deflection structure (after fastening).
[FIG. 7A] Fig. 7A is a cross-sectional view showing a modified example of the deflection structure (before fastening).
[FIG. 7B] Fig. 7B is a cross-sectional view showing the modified example (after fastening).
[FIG. 8] Fig. 8 is a perspective view of a high voltage device in an on-vehicle installation structure according to a third embodiment.

### DESCRIPTION OF EMBODIMENTS

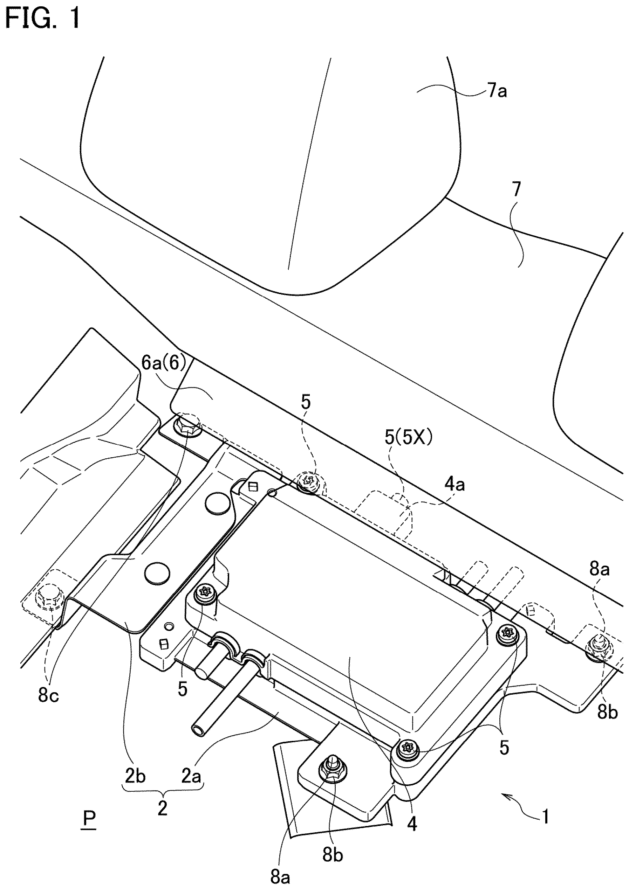

Hereinafter, embodiments of a structure for installing a high voltage device on a vehicle will be described with reference to the drawings. First, a first embodiment of a structure for installing a high voltage device on a vehicle will be described with reference to Fig. 1 through Fig. 4.

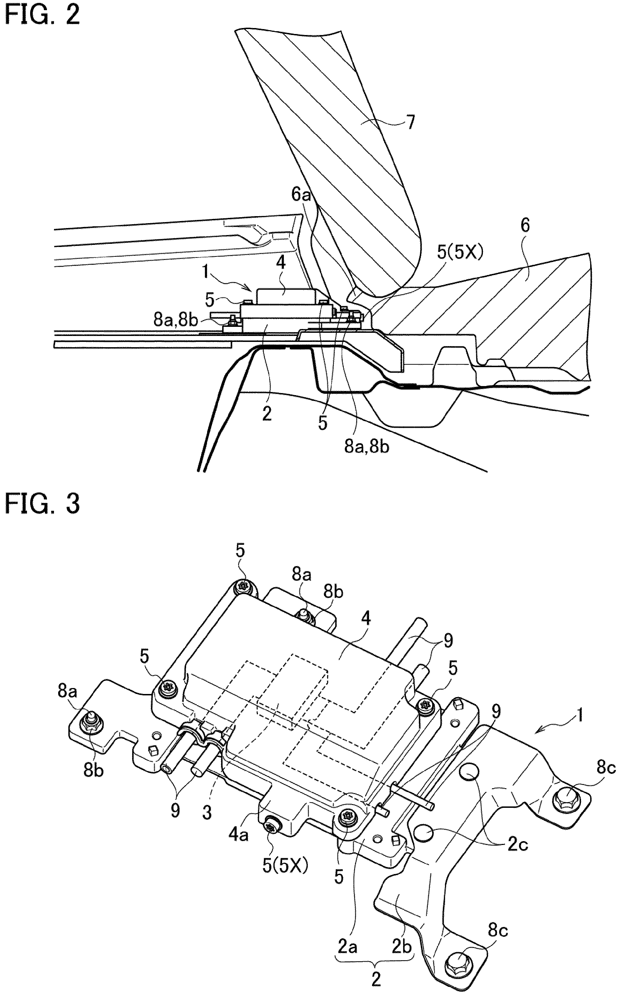

A vehicle in the present embodiment is a hybrid electric vehicle (HEV) or a battery electric vehicle (BEV), and a high voltage device 1 in the present embodiment is a junction box. The junction box controls high voltage connections and disconnections of a charging system, inverters, motors, a battery pack, and so forth. The high voltage device 1 houses a high voltage part 3 (see Fig. 3) within its inside, such as a controller (semiconductor chip) for operating the above controls.

As shown in Fig. 1, the high voltage device 1 has a base member 2 that is fixed on a mounting surface P in a passenger compartment (including a cargo compartment). The mounting surface P in the present embodiment is an upper face of a floor panel of the cargo compartment behind a rear seat installed within the passenger compartment. The rear seat includes a lower unit 6 that is a seat cushion and an upper unit 7 that is a seat back. As will be described in more detail later, the base member 2 in the present embodiment is configured by fastening a first member 2a made of aluminum alloy and a second member 2b made of pressed steel to each other. The above-mentioned high voltage part 3 (see Fig. 3) is disposed on the base member 2. The high voltage part 3 may be disposed directly on the first member 2a or may be disposed on the first member 2a with a printed circuit board or the like interposed therebetween.

An aluminum alloy cover member 4 is fixed to the base member 2 to protect the high voltage part 3. The cover member 4 is fixed to the base member 2 so as to cover the high voltage part 3 in order to prevent a user from easily removing it from the base member 2. The cover member 4 is fixed to the first member 2a of the base member 2 by three or more fasteners 5 (five fasteners 5 in the present embodiment). The fasteners 5 in the present embodiment are tamper-resistant hexarobular internal bolts. A tamper-resistant protrusion is formed in the center of its hexarobular hole, and the fasteners 5 can be fastened and removed only with a special tool.

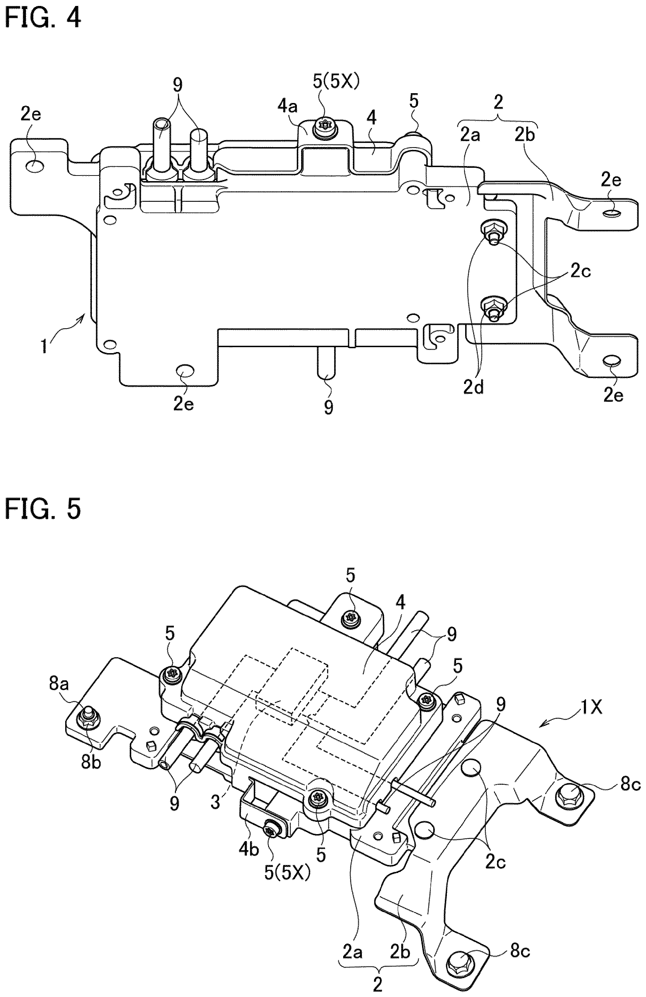

High voltage harnesses 9 (see Fig. 3) are electrically connected to the high voltage part 3, and the high voltage harnesses 9 are led out from the cover member 4, i.e., from the high voltage device 1. Mounting holes 2e (see Fig. 4) are formed in four corners of the base member 2 for mounting it onto the mounting surface P. Two of the mounting holes 2e are formed in the first member 2a and the other two of the mounting holes 2e are formed in the second member 2b. As shown in Fig. 1, weld bolts 8a are raised from the mounting surface P, and the weld bolts 8a are inserted into the mounting holes 2e of the first member 2a, respectively. Nuts 8b are fastened to the weld bolts 8a from above, respectively, and thus the first member 2a is fixed onto the mounting surface P.

On the other hand, bolts 8c are inserted into the mounting holes 2e of the second member 2b from above, respectively. The bolts 8c are fastened to weld nuts (not shown) provided at the mounting surface P, and thus the second member 2b is fixed onto the mounting surface P. As a result, the base member 2 is fixed to the mounting surface P. A trim member made of plastic is attached after fixing the high voltage device 1 to the mounting surface P, and thereby the rear bolt 8c is made hidden by the trim member. This makes it difficult to access the rear bolt 8c. The nuts 8b and the bolts 8c are fasteners that fix the base member 2 to the mounting surface P. The fastening direction of these fasteners is perpendicular to the mounting surface P. In the present embodiment, the mounting surface P is a horizontal surface, so the fastening direction of the nuts 8b and the bolts 8c is vertical.

The rear seat in the present embodiment includes the lower unit 6 (the seat cushion) and the upper unit 7 (the seat back), as described above. The lower unit 6 does not slide back and forth and is fixed to the floor panel. The upper unit 7 is attached to a rear end of the lower unit 6 or the floor panel via a hinge. A reclining angle of the upper unit 7 is adjustable and it can also be folded over the lower unit 6. Removable headrests 7a are attached to a top of the upper unit 7. The lower unit 6 is an interior component fixed in the passenger compartment adjacent to the high voltage device 1.

As described above, the cover member 4 is fixed to the base member 2 by the fasteners 5, but the fastening direction of one fastener 5X of the fasteners 5 to the base member 2 is set parallel to the mounting surface P. In the present embodiment, since the mounting surface P is a horizontal surface, this fastening direction is a horizontal direction, and more specifically, a front-back direction. The fastener 5X faces the lower unit 6 as the interior component in close proximity in the fastening direction. Therefore, even if someone tries to remove the fastener 5X, there is not enough space to insert a tool, which prevents the cover member 4 from being removed from the base member 2. Especially, in a case where the fastener 5X is an internal bolt with a hole for inserting a tool as in the present embodiment, the tool must be inserted into the hole along an axial direction of the internal bolt. Therefore, an accessing direction toward the fastener 5X is limited to the axial direction, and the fastener 5X cannot be removed without sufficient space in the axial direction. The fastening direction of the remaining fasteners 5 other than the fastener 5X to the base member 2 is set perpendicular to the mounting surface P. That is, this fastening direction is a vertical direction.

During vehicle assembly, the base member 2 is fixed to the mounting surface P before the lower unit 6 of the rear seat is fixed to the floor panel. After that, the high voltage harnesses 9 are connected to the high voltage part 3, and then the cover member 4 is fixed to the base member 2 by the fasteners 5 (including the fastener 5X). Since the lower unit 6 is not yet fixed to the floor panel, the fastener 5X can be easily fastened. The fasteners 5 other than the fastener 5X can be easily fastened, because their fastening direction is perpendicular to the mounting surface P. After fixing the cover member 4 to the base member 2, the lower unit 6 is fixed to the floor panel. This makes the fastener 5X difficult to be removed. The lower unit 6 may be fixed to the floor panel after the high voltage device 1, to which the high voltage harnesses 9 and the cover member 4 are already attached, is fastened to the mounting surface P.

In case of removing the cover member 4 from the base member 2 for some reasons such as malfunction, the fastener 5X has to be removed. In other words, the lower unit 6 has to be removed from the floor panel in order to remove the cover member 4 from the base member 2. Therefore, the cover member 4 can be prevented from being removed from the base member 2 by a user.

In the present embodiment, an eave 6a extends rearward from a rear edge of the lower unit 6 of the rear seat. The eave 6a of the lower unit 6 covers over an end edge of the high voltage device 1. Therefore, in the present embodiment, one of the fasteners 5 (an upper left fastener 5 in Fig. 1) whose fastening direction is perpendicular to the mounting surface P also faces the eave 6a, i.e., the above-mentioned lower unit 6 as the interior component, in close proximity in the fastening direction. Therefore, this fastener 5 is also made difficult to be removed after fixing the lower unit 6 to the floor panel. As a result, the cover member 4 can be further prevented from being removed from the base member 2 by a user.

In the present embodiment, moreover, two of the fasteners that fix the base member 2 to the mounting surface P, more specifically, the nut 8b and the bolt 8c on the front side also face the eave 6a, i.e., the above-mentioned lower unit 6 as the interior component, in close proximity in their fastening direction. Therefore, the nut 8b and bolt 8c on the front side are also made difficult to be removed after fixing the lower unit 6 to the floor panel. As a result, the base member 2 can be prevented from being removed from the mounting surface P by a user. If it is possible to remove the base member 2, i.e., the high voltage device 1, from the mounting surface P, it also becomes possible to access the fastener 5X afterwards. Therefore, the base member 2, i.e., the high voltage device 1, is also prevented from being removed from the mounting surface P in this manner in the present embodiment.

Note that the two of the fasteners (the nut 8b and the bolt 8c on the front side) that fix the base member 2 to the mounting surface P face the lower unit 6 as the interior component in close proximity in the present embodiment. However, if at least one of the fasteners that fix the base member 2 to the mounting surface P faces the eave 6a of the lower unit 6 as the interior component in close proximity, the base member 2, i.e., the high voltage device 1, can be prevented from being removed from the mounting surface P.

In addition, the interior component, to which the fastener 5X faces in close proximity, is the lower unit 6 in the present embodiment, and the interior component, to which the nut 8b and the bolt 8c on the front side face in close proximity, is also (the eave 6a of) the lower unit 6. However, at least one of the fasteners that fix the base member 2 to the mounting surface P may face another interior component in close proximity than the interior component to which the fastener 5X faces in close proximity. Also in such a case, the base member 2, i.e., the high voltage device 1, can still be prevented from being removed from the mounting surface P. For example, the upper unit 7 may be located so that no eave 6a is formed on the lower unit 6 and a lower end of the upper unit 7 faces the nut 8b or the bolt 8c on the front side in close proximity.

Furthermore, in the present embodiment, the base member 2 is comprised of the first member 2a and the second member 2b that are fastened to each other as described above. According to the configuration in which the base member 2 is comprised of the first member 2a and the second member 2b, positions of fastening points on the base member 2 can be flexibly set by combining the second member 2b, which may have a different shape depending on a vehicle model, with the first member 2a. The first member 2a and the second member 2b have an overlapping area in which they overlap each other in the direction perpendicular to the mounting surface P. In the overlapping area, the second member 2b is located on the opposite side of the first member 2a to the mounting surface P, i.e., on the upper side thereof. Further, as shown in Fig. 4, the second member 2b is fastened to the first member 2a in the overlapping area by nuts 2d from a side of the mounting surface P, i.e., from below. The nuts 2d are fasteners that fasten the first member 2a and the second member 2b to each other.

More specifically, two weld bolts 2c are protruded toward the first member 2a, i.e., downwardly, in the overlapping area of the second member 2b. These weld bolts 2c are inserted into insertion holes (not shown in the drawings) formed on the first member 2a, and the above-mentioned nuts 2d are fastened to the weld bolts 2c. Therefore, to separate the first member 2a from the second member 2b, it is needed to access the nuts 2d from the back side of the base member 2. The nuts 2d cannot be accessed when the base member 2 is fixed to the mounting surface P, and the base member 2 has to be removed from the mounting surface P to access the nuts 2d.

However, as mentioned above, the base member 2 cannot be removed from the mounting surface P without removing the lower unit 6 from the floor panel because the nut 8b and the bolt 8c on the front side face the eave 6a in close proximity. In other words, separation of the first member 2a from the second member 2b by a user is also prevented. As a result, it is also impossible to access the fastener 5X by forcibly rotating the first member 2a about the weld bolt 8a on the front side after separating the first member 2a from the second member 2b and then removing the accessible nut 8b on the rear side. Since the first member 2a cannot be separated from the second member 2b, it is impossible to access the fastener 5X as described above.

Next, a second embodiment of a structure for installing a high voltage device on a vehicle will be described with reference to Fig. 5 through Fig. 6B. In the high voltage device 1 of the first embodiment, the fastener 5X, to which access is prevented, is fastened at a box portion 4a of the cover member 4 (see Fig. 3 and Fig. 4). In the high voltage device 1X of the present embodiment, the fastener 5X, to which access is prevented, is fastened at a cantilever tab 4b of the cover member 4, which has a deflection structure. With this configuration, an overall shape of the cover member 4 is slightly different from that of the first embodiment, but the other configurations are the same as in the first embodiment. Although the relationship with the lower unit 6 as the interior component is not shown in the drawings, it is also similar to that of the first embodiment. Hereinafter, only configurations that differ from those of the first embodiment will be described, and identical and equivalent configurations will be labelled with the identical reference signs and their descriptions will be omitted.

The box portion 4a of the first embodiment is not easily deflected due to its box shape. Therefore, when fastening the fastener 5X at the box portion 4a, a gap may be formed between an inner surface of the box portion 4a and the base member 2. This possibility will increase, especially when fastening the fastener 5X after fastening the fasteners 5 other than the fastener 5X. According to the fastening of the fastener 5X where a gap is formed between the inner surface of the box portion 4a and the base member 2, there is a possibility that the fastening of the fastener 5X may get loose due to vibrations caused by vehicle running.

The cover member 4 is formed of aluminum alloy in the present embodiment, but a creep phenomenon may occur even with aluminum alloy. If a creep phenomenon occurs at the box portion 4a due to the fastening force acting on the portion of the box portion 4a where the fastener 5X is fastened, the fastener 5X may get loose more easily. Therefore, the portion where the fastener 5X is fastened is formed as the cantilever tab 4b having the deflection structure in the present embodiment, and thus the cantilever tab 4b is securely contacted with the base member 2 by the fastening force of the fastener 5X. As a result, the fastener 5X can be securely prevented from getting loose.

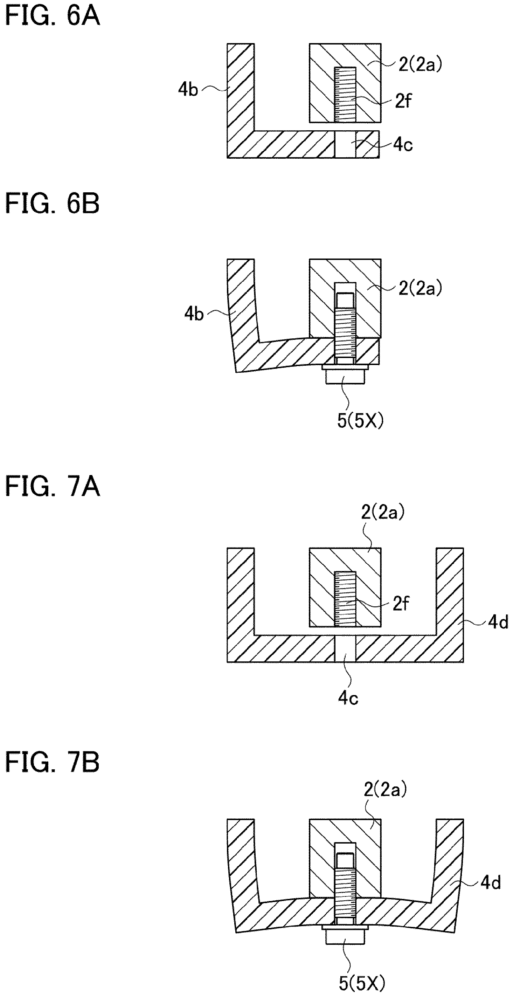

The deflection structure of the cantilever tab 4b will be explained with reference to Fig. 6A and 6B. As shown in Fig. 6A, the base member 2 has a female screw hole 2f into which the fastener 5X are fastened. On the other hand, a bolt hole 4c through which the fastener 5X is inserted is formed on the cantilever tab 4b such that it is associated with the female screw hole 2f. The cantilever tab 4b has an L-shaped form extending out from the main body of the cover member 4, and the bolt hole 4c is formed near its free end.

When the fastener 5X is fastened to the female screw hole 2f as shown in Fig. 6B, the fastening force of the fastener 5X causes the cantilever tab 4b to deflect and thus the cantilever tab 4b is made securely contacted with the base member 2. As a result, the fastening force effectively acts between the fastener 5X and the base member 2, and thereby the cover member 4 is firmly fixed to the base member 2. This secure fastening can effectively resist vibrations and can prevent the fastener 5X from getting loose.

Fig. 7A and Fig. 7B show a modified example of the second embodiment, i.e., a modified example of the deflection structure. The cantilever tab 4b is formed as the deflection structure in the above second embodiment, but a bridge portion 4d is formed as the deflection structure in this modified example. The bridge portion 4d has a gate-shaped form extended from the main body of the cover member 4 as shown in Fig. 7A, and the bolt hole 4c is formed at its center. Both ends of the bridge portion 4d are integrally connected to the main body of the cover member 4.

When the fastener 5X is fastened to the female screw hole 2f as shown in Fig. 7B, the fastening force of the fastener 5X causes the bridge portion 4d to deflect and thus the bridge portion 4d is made securely contacted with the base member 2. As a result, the fastening force effectively acts between the fastener 5X and the base member 2, and thereby the cover member 4 is firmly fixed to base member 2. This secure fastening can effectively resist vibrations and can prevent the fastener 5X from getting loose.

The cantilever tab 4b and the bridge portion 4d are shown as specific examples of the deflection structure in the second embodiment and the modified example thereof, respectively. However, the deflection structure is not limited to the cantilever tab 4b and the bridge portion 4d, as long as the structure securely makes the cover member 4 contacted with the base member 2 without forming a gap by locally deflecting the cover member 4 at the portion where the fastener 5X is fastened. In addition, the local deflection of the cover member 4 caused by the deflection structure may be elastic or plastic deformation.

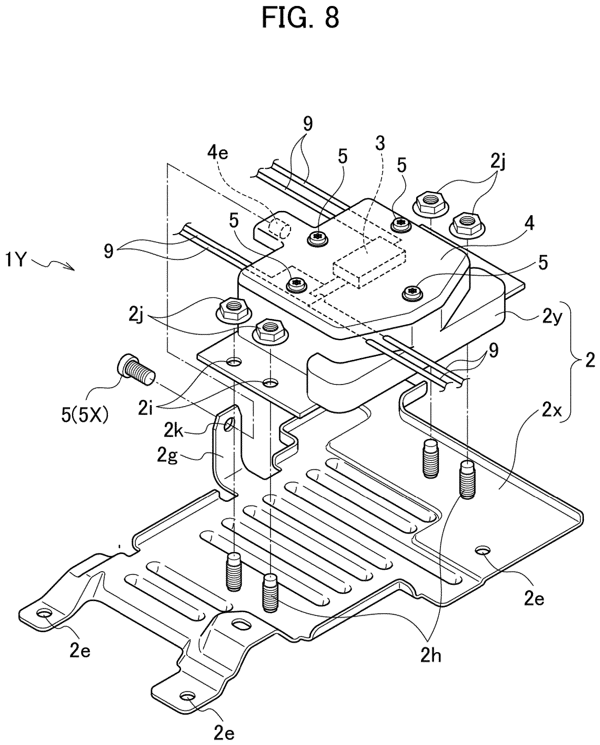

Next, a third embodiment of a structure for installing a high voltage device on a vehicle will be described with reference to Fig. 8. The deflection structure is provided on the cover member 4 in the second embodiment and the modified example thereof described above. In the present embodiment, the deflection structure is provided on the base member 2. More specifically, a fixing tab 2g is raised from the base member 2 perpendicularly to the mounting surface P, and this fixing tab 2g deflects similarly to the second embodiment and the modified example to make the cover member 4 securely contacted with the base member 2 without forming a gap. Although the relationship with the lower unit 6 as the interior component is not shown in the drawings, it is also similar to that of the first embodiment. Hereinafter, only configurations that differ from those of the first embodiment will be described, and identical and equivalent configurations will be labelled with the identical reference signs and their descriptions will be omitted.

Also in a high voltage device 1Y of the present embodiment, its base member 2 is configured by fastening a base plate 2x made of pressed steel and a base housing 2y made of aluminum alloy to each other. The high voltage part 3 is provided on the base housing 2y of the base member 2. High voltage harnesses 9 are electrically connected to the high voltage part 3 similarly to the above embodiments. Note that the base plate 2x and the base housing 2y may be monolithically formed of aluminum alloy, for example.

The mounting holes 2e are formed on the base plate 2x similarly to the above embodiments and it is fixed to the mounting surface P by the weld bolts 8a, the nuts 8b and the bolts 8c similarly to the above embodiments. Four weld bolts 2h are raised from the base plate 2x. Insertion holes 2i, through which the weld bolts 2h are inserted respectively, are formed on bottom flanges of the base housing 2y so as to be associated with the weld bolts 2h. Nuts 2j are fastened to the weld bolts 2h, which have been inserted into the insertion holes 2i, to fix the base housing 2y to the base plate 2x. The above-mentioned fixing tab 2g is raised from the base plate 2x perpendicularly to the mounting surface P.

The cover member 4 made of aluminum alloy for protecting the high voltage part 3 is fixed to the base member 2 (the base plate 2x or the base housing 2y) by the five fasteners 5 (including the fastener 5X) also in the present embodiment. The fasteners 5 in the present embodiment are also tamper-resistant hexarobular internal bolts. Similarly to the above embodiments, the fastening direction of the fastener 5X to the base member 2 (the base plate 2x) is set parallel to the mounting surface P. The insertion hole 2k through which the fastener 5X is inserted is formed near the free end of the above-mentioned fixing tab 2g of the base member 2.

The Fastening hole 4e, through which the fastener 5X is fastened, is formed in the cover member 4. The fastener 5X in the present embodiment does not fasten the cover member 4 to the base housing 2y, but it fastens the cover member 4 to the fixing tab 2g of the base plate 2x via the fastening hole 4e. In other words, the cover member 4 is fixed to the base member 2 (the base plate 2x) at the fixing tab 2g by the fastener 5X whose fastening direction is parallel to the mounting surface P.

The fastener 5X can be prevented from being removed also according to the configuration of the present embodiment, because the fastener 5X, whose fastening direction is parallel to the mounting surface P, faces the interior component (the lower unit 6) in close proximity. As a result, the high voltage part 3 housed within the high voltage device 1Y can be prevented from being accessed by a user. In other words, the user can be protected from high voltage. Also in the present embodiment, one of the fasteners 5 whose fastening direction is perpendicular to the mounting surface P (the fastener 5 closest to the fastening position of the fastener 5X in Fig. 8) also faces the eave 6a in the fastening direction, i.e., faces the above-mentioned lower unit 6 as the interior component in close proximity. Therefore, this fastener 5 is also made difficult to be removed after fixing the lower unit 6 to the floor panel. As a result, the cover member 4 can be further prevented from being removed from the base member 2 (the base housing 2y) by a user.

In addition, two of the fasteners that fix the base member 2 (the base plate 2x) to the mounting surface P, specifically, the nut 8b and bolt 8c fastened to the mounting holes 2e on the front side, also face the eave 6a of the lower unit 6 as interior components in close proximity in their fastening direction. Therefore, the nut 8b and the bolt 8c on the front side are also made difficult to remove after fixing the lower unit 6 to the floor panel. As a result, the base member 2 can be prevented from being removed from the mounting surface P by a user.

According to the embodiments and the modified example that are described above, the cover member 4 is fixed to the base member 2 by the three or more fasteners 5. The fastening direction of at least one fastener 5X of the fasteners 5 to the base member 2 is set parallel to the mounting surface P, and the above at least one fastener 5X faces the interior component (lower unit 6) in close proximity in the fastening direction. In addition, the fastening direction of all or some remaining fasteners 5 of the fasteners 5 to the base member 2 is set perpendicular to the mounting surface P. Since the fastener 5X faces the interior component (the lower unit 6) in close proximity, the fastener 5X can be prevented from being removed. As a result, the high voltage part 3 housed within the high voltage device 1, 1X can be prevented from being accessed. In other words, a user can be protected from high voltage.

According to the second embodiment and the modified example that are described above, the cover member 4 has the deflection structure (the cantilever tab 4b, the bridge portion 4d, etc.) at the portion where the fastener 5X is fastened. Therefore, at the portion where the fastener 5X is fastened, the cover member 4 can be securely contacted with the base member 2 by the fastening force of the fastener 5X. As a result, the fastener 5X can be prevented from getting loose.

According to the third embodiment described above, the fixing tab 2g is raised from the base member 2 perpendicularly to the mounting surface P, and the cover member 4 is fixed to the base member 2 at the fixing tab 2g by the fastener 5X whose fastening direction is parallel to the mounting surface P. Also in this case, the fixing tab 2g deflects and thereby the base member 2 (the fixing tab 2g) can be made securely contacted with the cover member 4 by the fastening force of the fastener 5X. As a result, the fastener 5X can be prevented from getting loose.

In addition, according to the embodiments and the modified example that are described above, the base member 2 is fixed to the mounting surface P by the two or more fasteners (the nuts 8b and the bolts 8c), and the fastening direction of the two or more fasteners (the nuts 8b and the bolts 8c) to the mounting surface P is set perpendicular to the mounting surface P. At least one of these fasteners (the nuts 8b and the bolts 8c) faces the interior component (the eave 6a of the lower unit 6) in close proximity in the fastening direction. Since the at least one of the fasteners faces the interior component in close proximity, the at least one fastener can be prevented from being removed. As a result, the base member 2, i.e., the high voltage device 1, 1X, can be prevented from being removed from the mounting surface P by a user. If the high voltage device 1, 1X is removed from the mounting surface P, it becomes possible to access the fastener 5X. However, by preventing the high voltage device 1, 1X from being removed from the mounting surface P, the high voltage part 3 housed within the high voltage device 1, 1X can be further prevented from being accessed by a user. Note that the interior component, which the at least one of the fasteners (the nuts 8b and the bolts 8c) that fix the base member 2 to the mounting surface P faces in close proximity, and the interior component, which the fastener 5X faces in close proximity, may be identical to each other or different from each other.

Furthermore, according to the second embodiment and the modified example that are described above, the base member 2 is comprised of the first member 2a and the second member 2b that are fastened to each other. The first member 2a and the second member 2b have an overlapping area in which they overlap each other in the direction perpendicular to the mounting surface P. In the overlapping area, the second member 2b is located on the opposite side of the first member 2a to the mounting surface P. The second member 2b is fastened to the first member 2a in the overlapping area from a side of the mounting surface P by the fasteners (the nuts 2d). Since the fasteners (the nuts 2d) are located between the base member 2 and the mounting surface P, the fasteners (the nuts 2d) can be prevented from being accessed by a user if the base member 2, i.e., the high voltage device 1, 1X is prevented from being removed from the mounting surface P by a user as described above. Therefore, the base member 2 can also be prevented from being separated into the first member 2a and the second member 2b, and thus the fastener 5X can be reliably prevented from being accessed by a user. In addition, in a case where the base member 2 is comprised of the first member 2a and the second member 2b, the positions of the fastening points on the base member 2 can be flexibly set by combining the second member 2b and the first member 2a, which may respectively have different shapes, with each other.

The high voltage device 1, 1X in the above embodiments and the modified example is the junction box, but is not limited to this. A high voltage device in the present invention may be any device that is mounted in a passenger compartment (including a cargo compartment) and copes with high voltage. For example, a converter unit, an inverter unit or the like may be the high voltage device. Note that, as described above, the high voltage referred to here is a voltage of 60 volts or higher. The high voltage device installed on a vehicle requires a dedicated ground circuit instead of body ground, and its harnesses are made orange to distinguish them from other wirings. The mounting surface P of the high voltage device 1, 1X in the embodiments is a horizontal surface, but it may also be a vertical or inclined surface, such as a surface of a side panel of a passenger compartment (including a cargo compartment).

In the above embodiments and the modified example, the number of the fastener 5X having its fastening direction parallel to the mounting surface P is one. However, two or more fasteners may have a fastening direction parallel to the mounting surface P. And it is sufficient if at least one of the two or more fasteners having the fastening direction parallel to the mounting surface P faces the interior component in close proximity in the fastening direction. In addition, all the fasteners 5, except for the fastener 5X having the fastening direction parallel to the mounting surface P, are fastened perpendicular to the mounting surface P in the above embodiments. However, only some of the fasteners 5, except for the fastener 5X having the fastening direction parallel to the mounting surface P, may be fastened perpendicular to the mounting surface P.

In the above embodiments and the modified example, the interior component located in close proximity to the fastener 5X having the fastening direction parallel to the mounting surface P is the lower unit 6 of the rear seat. However, the interior component located in close proximity to the fastener 5X is not limited to this, and may be a center console, for example. In this case, the high voltage device is located on a foot space for the rear seat behind the center console.

In the above embodiments and the modified example, the base member 2 is comprised of the first member 2a and the second member 2b that are fastened to each other. However, the base member 2 may be formed as a single member. In addition, the cover member 4 is made of aluminum alloy in the embodiments and the modified example, but it may be made of pressed steel. It may be easier to form the cantilever tab 4b and the bridge portion 4d of the cover member 4 mentioned above by press forming. Furthermore, the cantilever tab 4b or the bridge portion 4d that is press-formed may be more effectively deflected.

### REFERENCE SIGNS LIST

- 1, 1X, 1Y: high voltage device
- 2: base member
- 2a: first member
- 2b: second member
- 2d: nut (fastener between the first member 2a and the second member 2b)
- 2g: fixing tab
- 3: high voltage part
- 4: cover member
- 4b: cantilever tab (deflection structure)
- 4d: bridge portion (deflection structure)
- 5, 5X: fastener (for fastening the cover member 4 to the base member 2)
- 6: lower unit (of a rear seat) (interior component)
- 6a: eave (of the lower unit 6)
- 8b: nut (fastener for fastening the base member 2 to the mounting surface P)
- 8c: bolt (fastener for fastening the base member 2 to the mounting surface P)
- 9: high-voltage harness
- P: mounting surface (of the high voltage device 1, 1X, IY)

## Claims

1. A structure for installing a high voltage device on a vehicle, the structure comprising:
the high voltage device that includes a base member fixed on a mounting surface in a passenger compartment, a high voltage part provided on the base member, and a cover member fixed to the base member to cover the high voltage part, and
an interior component that is fixed in the passenger compartment adjacent to the high voltage device,
wherein the cover member is fixed to the base member by three or more fasteners,
wherein a fastening direction of at least one fastener of the fasteners to the base member is set parallel to the mounting surface, and the at least one fastener faces the interior component in close proximity in the fastening direction, and
wherein a fastening direction of all or some remaining fasteners of the fasteners to the base member is set perpendicular to the mounting surface.

2. The structure for installing the high voltage device on a vehicle, according to claim 1,
wherein the cover member has a deflection structure at a portion thereof where the fastener whose fastening direction is parallel to the mounting surface is fastened.

3. The structure for installing the high voltage device on a vehicle, according to claim 1,
wherein a fixing tab is raised from the base member perpendicularly to the mounting surface, and
wherein the cover member is fixed to the base member at the fixing tab by the fastener whose fastening direction is parallel to the mounting surface.

4. The structure for installing the high voltage device on a vehicle, according to any one of claims 1 to 3,
wherein the base member is fixed to the mounting surface by two or more fasteners, and a fastening direction of the two or more fasteners to the mounting surface is set perpendicular to the mounting surface, and
wherein at least one of the two or more fasteners faces the interior component or another interior component provided in the passenger compartment in close proximity in the fastening direction.

5. The structure for installing the high voltage device on a vehicle, according to claim 4,
wherein the base member is comprised of a first member and a second member that are fastened to each other,
wherein the first member and the second member have an overlapping area in which the first member and the second member overlap each other in a direction perpendicular to the mounting surface,
wherein, in the overlapping area, the second member is located on an opposite side of the first member to the mounting surface, and
wherein the second member is fastened to the first member in the overlapping area from a side of the mounting surface by a fastener.
